# EUROPEAN PATENT APPLICATION

(11) **EP 4 184 569 A2**
(43) Date of publication of application: **24.05.2023**
(21) Application number: 22201685.9
(22) Date of filing: 14.10.2022
(51) Int. Cl.: H01L 23/485, H01L 21/603, H01L 25/065, H05K 3/34

(54) **MICROELECTRONIC PACKAGES WITH REGULAR SOLDER JOINTS AND NO-REMELT, FULL INTERMETALLIC COMPOUND JOINTS BETWEEN TWO SUBSTRATES**

(30) Priority: 02.11.2021 US 202117517152
(71) Applicant: INTEL Corporation, Santa Clara, CA 95054 (US)
(72) Inventor: SHAN, Bohan, Chandler, 85226 (US); CHEN, Haobo, Chandler, 85249 (US); KARHADE, Omkar, Chandler, 85248 (US); SANKARASUBRAMANIAN, Malavarayan, Tempe, 85282 (US); XU, Dingying, Chandler, 85248 (US); DUAN, Gang, Chandler, 85248 (US); NIE, Bai, Chandler, 85249 (US); GUO, Xiaoying, Chandler, 85248 (US); DARMAWIKARTA, Kristof, Chandler, 85249 (US); FENG, Hongxia, Chandler, 85249 (US); PIETAMBARAM, Srinivas V., Chandler, 85249 (US); ECTON, Jeremy, Gilbert, 85298 (US)
(74) Representative: 2SPL Patentanwälte PartG mbB

(57) **Abstract**

In a microelectronic package, one or more solder joints (130A-B, 206A-D, 226, 640) between two substrates (102, 104, 202A, 202B, 204, 224, 228, 600, 630) are formed as full IMC (intermetallic compound) solder joints, while other solder joints (132, 210, 220, 642) may be formed as regular solder joints. The full IMC solder joint (130A-B, 206A-D, 226, 640) includes a continuous layer (e.g., from a top pad (124, 128, 636) to a bottom pad (122, 126, 606)) of intermetallic compounds and may include copper particles (302) throughout the full IMC solder joints (130A-B, 206A-D, 226, 640). The full IMC solder joint (130A-B, 206A-D, 226, 640) may include cured epoxy from a no-remelt solder around the continuous layer of IMCs. The full IMC solder joint (130A-B, 206A-D, 226, 640) has a melting point that is higher than that of the regular solder joints (132, 210, 220, 642). The full IMC solder joint (130A-B, 206A-D, 226, 640) may be between dummy pads (126, 128, 606, 636) on the first and second substrates (102, 104, 600, 630) or may include an interconnect for power delivery between the first substrate (102, 600) and the second substrate (104, 630) or an input/output (I/O) interconnect between the first substrate (102, 600) and the second substrate (104, 630). The first substrate (102, 204, 224, 600) and the second substrate (104, 202A, 202B, 228, 630) may include one or more of: a substrate, a die, a bridge die, an interposer, a patch, a thin film, a motherboard, a redistribution layer (RDL), and an organic PCB, in particular, the first substrate (204) may be a core substrate and the second substrate (202A, 202B) may be a substrate patch, or the full IMC solder joint (226) may be located in a via (222) in the first substrate (224), wherein the second substrate may be a bridge die (228). The solder joints (130A-B, 206A-D, 226, 640) may include at least three full IMC solder joints, wherein the number of full IMC solder joints is in a range of one solder joint to 50% of all solder joints. In a method of manufacturing the microelectronic package, regular solder (602) is dispensed on a plurality of conductive contacts (604) of a first substrate (600), no-remelt solder (620) is dispensed on another conductive contact (606) of the first substrate (600), and a second substrate (630) is bonded to the first substrate (600), forming the full IMC solder joint (640) from the no-remelt solder (620). The no-remelt solder (620) may be a TLPS (transient liquid phase sintering) paste, e.g., a solder paste that includes copper (Cu) particles together with tin (Sn) or tin alloy (such as Sn-Bi) particles dispersed in a flux system, such as an epoxy flux. The no-remelt solder (620) may have a higher melting point than the regular solder (602). The location of the full IMC solder joints (130A-B, 206A-D, 226, 640) may be selected to maximize mechanical stability both during downstream reflow (eliminating die or substrate movement, during multiple thermal processing steps (e.g., reflow steps) while forming hierarchical interconnections) and of the final package. For example, the full IMC joints (130A-B, 206A-D, 226, 640) may be formed in areas other than corners to prevent cracking. The full IMC (130A-B, 206A-D, 226, 640) joints may also be distributed (e.g., distributed uniformly) amongst the regular solder joints to increase stability during assembly in all areas between the substrates.

## Description

### FIELD

The descriptions are generally related to semiconductor devices, and in specific examples, microelectronic packages and assemblies with no-remelt solder enforcement joints.

### BACKGROUND

Microelectronic packaging technology is evolving towards 2.5D (2.5-dimensional) and 3D (three-dimensional) packaging, in which multiple substrates or dies are stacked and bonded. Hierarchical interconnection solutions are becoming more common to enable more complicated 2.5D and 3D architectures.

### BRIEF DESCRIPTION OF THE DRAWINGS

The following description includes discussion of figures having illustrations given by way of example of implementations of embodiments of the invention. The drawings should be understood by way of example, and not by way of limitation. As used herein, references to one or more "embodiments" are to be understood as describing at least one implementation of the invention that includes one or more particular features, structures, or characteristics. Thus, phrases such as "in one embodiment" or "in an alternate embodiment" appearing herein describe various embodiments and implementations of the invention, and do not necessarily all refer to the same embodiment. However, they are also not necessarily mutually exclusive.
**Figure 1** is a cross-sectional view of a portion of a package or microelectronic assembly with a full IMC solder joint.
**Figure 2A** is a cross-sectional view of an assembly including two patches attached to a core substrate.
**Figure 2B** illustrates an assembly with a bridge die between a die and a substrate.
**Figures 3A-3C** illustrate full IMC joint formation with a solder paste.
**Figure 4** illustrates a drawing of an example of IMCs post reflow.
**Figure 5** is a flow chart illustrating a method of assembling substrates, including forming one or more full IMC joints.
**Figures 6A-6D** illustrate cross-sectional views of various stages corresponding to the process of Figure 5.
**Figure 7** provides an exemplary depiction of a computing system that may include one or more packages in accordance with the packages described herein.

Descriptions of certain details and implementations follow, including a description of the figures, which may depict some or all of the embodiments described below, as well as discussing other potential embodiments or implementations of the inventive concepts presented herein.

### DETAILED DESCRIPTION

No-remelt solder enforcement joints are described herein.

With the packaging technology evolving towards 2.5D (2.5 dimensional) and 3D (three-dimensional) packaging, hierarchical interconnection solutions are becoming more common to enable more complicated architectures. Examples of hierarchical interconnections include die-to-die, die-to-RDL (redistribution layer), die-to-substrate, and other hierarchical interconnections. Forming such hierarchical interconnections typically involves multiple thermal processing steps (e.g., re-flow steps). Along with different assembly process flows, the downstream solder reflow processes may expose pre-formed solder joints to high temperatures and stress, which subsequentially can lead to die movement or reliability risks. For example, one level of interconnections is formed, followed by formation of a second level of interconnections. Forming subsequent levels of interconnections can cause the previously formed levels of interconnections to soften, posing risks to the assembly process.

One technique for minimizing die or substrate movement during downstream re-flow processes is to use a combination of high-temperature solder and low-temperature solder to create hierarchical reflow profiles (e.g., high-temperature solder between first level interconnects, and low-temperature solder between subsequent level interconnects). However, using a mix of high-temperature solder and low-temperature solder has the disadvantage of introducing LTS solder, which typically involves additional Bismuth or Indium to form a new metallurgy, which can create additional cost and reliability risks.

In one example, no-remelt solder joints can eliminate die or substrate movement in downstream reflow processes. In one example, one or more solder joints between two substrates can be formed as full IMC (intermetallic compound) solder joints. In one example, a full IMC solder joint includes a continuous layer (e.g., from the top pad to bottom pad) of intermetallic compounds. In one example, a full IMC joint can be formed by dispensing a no-remelt solder paste on some of the pads of one or both substrates to be bonded together. In one example, the no-remelt solder paste includes copper particles in the paste. In one such example, a regular solder paste is dispensed on the other pads of the one or both substrates. The substrates are then bonded together (e.g., via a thermocompression process), forming both regular solder joints and full IMC solder joints. In one example, the full IMC solder joints provide stable anchoring points that prevent movement of the substrates in subsequent thermal processes.

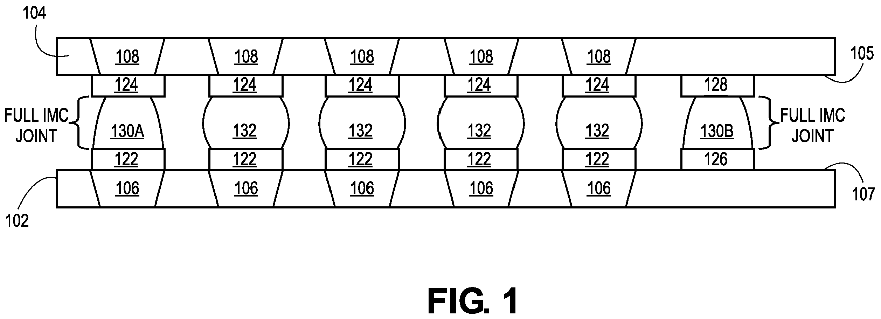

**Figure 1** is a cross-sectional view of a portion of a package or microelectronic assembly with a full IMC solder joint. The package or assembly depicted in Figure 1 includes a first substrate 102 coupled with a second substrate 104. In the illustrated example, the second substrate 104 is over (e.g., vertically stacked over) the first substrate 102. The substrates 102 and 104 can include one or more of: a substrate, a die, a bridge die, an interposer, a patch, a thin film, a motherboard, a redistribution layer (RDL), and an organic PCB. For ease of reference, examples in the following description refer generally to two substrates being bonded together; however, this is intended to refer to any two substrates bonded together. For example, any of a substrate, a die, a bridge die, an interposer, a patch, a thin film, a motherboard, a redistribution layer (RDL), and an organic PCB bonded to a substrate, a die, a bridge die, an interposer, a patch, a thin film, a motherboard, a redistribution layer (RDL), or an organic PCB.

Turning again to Figure 1, the substrates 102 and 104 are bonded together via a plurality of solder joints 130A-130B and 132. Thus, the solder joints 130A-130B and 132 are located between the substrates 102 and 104. The solder joints physically couple the substrates 102 and 104 with one another, and at least some of the solder joints electrically couple the substrates 102 and 104. For example, the solder joints 130A and 132 connect interconnects 106 of the first substrate 102 with interconnects 108 of the second substrate 104.

The plurality of solder joints includes two full IMC solder joints 130A and 130B and regular solder joints 132. In one example, the full IMC solder joints 130A and 130B are formed from the pads and no-remelt solder dispensed on one or both opposing pads in a bonding process. For example, the full IMC solder joint 130A is formed from the pads 124 and 122 and no-remelt solder paste, and the full IMC solder joint 130B is formed from the pads 126 and 128 and no-remelt solder paste. Similarly, the regular solder joints 132 are formed with solder paste between respective pads 122 and pads 124. In one example, the pads 122, 124, 126, and 128 are formed from a conductive material such as copper or another metal on the surfaces 105 and 107 of the substrates 104 and 102, respectively. In another example, the solder may be dispensed between opposing conductive contacts other than pads, such as exposed conductive contacts of one of the substrates without pads.

In contrast to the regular solder joints 132 formed with a conventional solder paste, the full IMC solder joints 130A and 130B include a continuous layer of intermetallic compounds (IMCs) between respective contacts. For example, the full IMC solder joint includes a continuous layer of IMCs from the upper conductive contact 124 of the second substrate 104 to the lower conductive contact 122 of the first substrate 102. The continuous layer of IMCs in the solder joint form a mechanically rigid body that does not soften or re-melt when subject to typical solder reflow temperatures. In contrast, regular solder joints do not include a continuous layer of IMCs throughout the joint. Thus, including one or more full IMC joints between two substrates can create anchoring points between the substrates that are mechanically stable during subsequent thermal operations, minimizing the risk of substrate movement.

In one example, a combination of regular solder joints and full IMC joints are formed between substrates. For example, one or more locations between the substrates can be selected to form full IMC solder joints instead of regular solder joints. The IMC solder joints add mechanical stability but can be more brittle than regular solder joints. Therefore, a combination of regular solder joints and full IMC solder joints between the substrates can enable improved mechanical stability throughout the assembly process without compromising the reliability of the final package.

The ratio of full IMC joints to regular solder joints may vary and depend on the application. A package may include a single full IMC joint between two substrates, or more than one full IMC joint (e.g., two, three, or more full IMC joints) between two substrates. In one example, the number of full IMC joints is in a range of: one solder joint to 50% of the plurality of the solder joints between two substrates. The location of the full IMC solder joints may be selected to maximize mechanical stability both during downstream re-flow and of the final package. For example, the full IMC joints may be formed in areas other than corners to prevent cracking. In one example, the full IMC joints may be distributed (e.g., distributed uniformly) amongst the regular solder joints to increase stability during assembly in all areas between the substrates.

The full IMC joints may be formed between interconnects for input/output (I/O), power delivery, or between "dummy" pads that are not connected to I/O or power interconnects. The example in Figure 1 depicts one full IMC joint 130A that is electrically coupled with a respective interconnect 106 of the first substrate 102 and a respective interconnect 108 of the second substrate 104. The example in Figure 1 also depicts a full IMC joint 130B between dummy pads 126 and 128. The dummy pads 126 and 128 are electrically isolated from conductive interconnects for I/O and power delivery in the first and second substrates 102 and 104. Thus, the full IMC joints between dummy pads can improve the mechanical stability of the package during assembly, while the regular solder joints provide the power and I/O functions. In other examples, the full IMC solder joints can be used to connect one or more I/O or power interconnects.

Thus, according to one example, no-remelt solder paste is dispensed on contacts of one or both substrates to be bonded. For example, the no-remelt solder paste can be dispensed on I/O, power, or dummy copper pads. During die attach or substrate attach, regular solders will provide bond head force for z-height adjustment and form solder joint to provide electrical connection and the no re-melt solder paste forms full IMC joints. After the full IMC joints are formed, the full IMC joints can prevent die or substrate movement during downstream reflow steps even though regular solder joint may soften. Combining full IMC enforcement joints and regular solder joints can eliminate the reliability and electrical performance risks of using full IMC joints across the entire unit. The power and I/O functions can be achieved by regular solder bumps as well as the z-height control capability, which can a problem for pure solder paste.

Note that although the full IMC joints 130A and 130B and the regular solder joints 132 are depicted as having the same pitch, the full IMC joints 130A and 130B may have the same or a different pitch than regular solder joints.

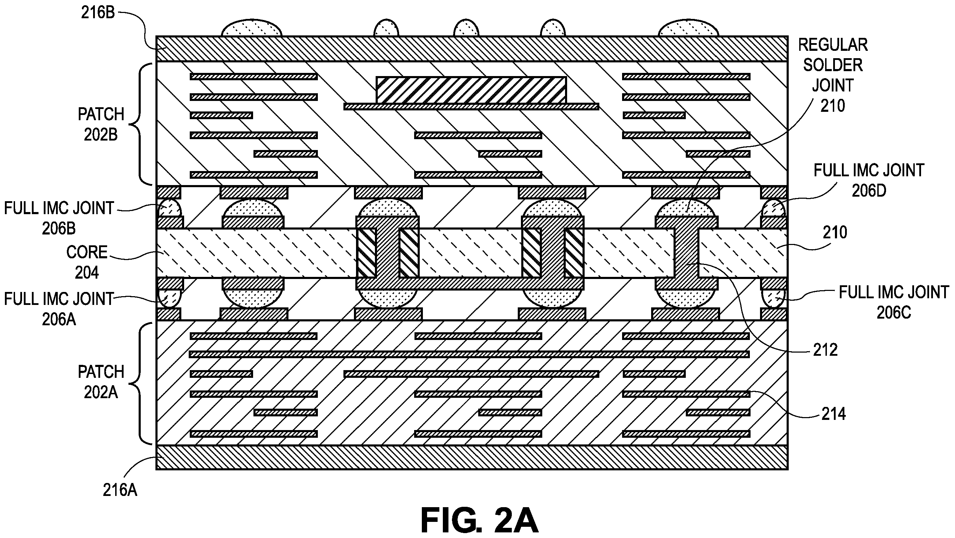

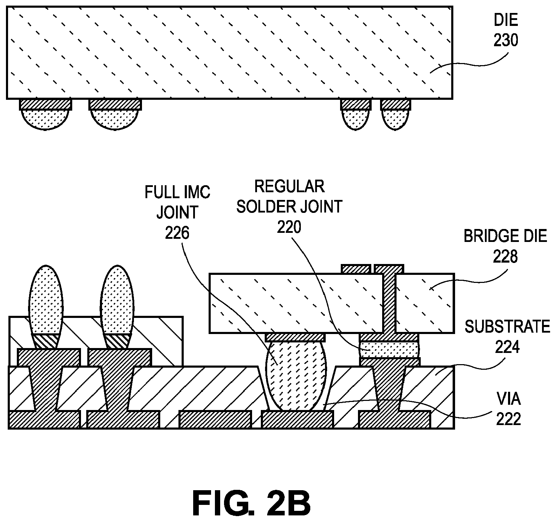

**Figures 2A** **and** **2B** illustrate examples of microelectronic assemblies in which full IMC joints may be implemented. **Figure 2A** is a cross-sectional view of an assembly including two patches attached to a core substrate. **Figure 2B** illustrates an assembly with a bridge die between a die and a substrate.

Referring to Figure 2A, one or more full IMC joints can be included in a package having a disaggregated architecture with multiple substrate segments or "patches" that are assembled together. Thus, rather than manufacturing a single substrate, substrate patches can be separately processed and later assembled, reducing the processing steps that each patch is subject to. The Example in Figure 2A depicts a core substrate 204 onto which patches 202A and 202B are attached. In this example, the core substrate 204 provides mechanical support for the assembly and includes conductive interconnects for electrically coupling the patches 202A and 202B with one another. For example, the core substrate 204 includes conductive vias 212. In one example, the patches 202A and 202B are substrate segments, and in one example include an organic PCB (printed circuit board) with circuitry and conductive interconnects 214 in or on the patches. In the illustrated example, routing PCBs 216A and 216B enable further connections to circuitry or interconnects under the patch 216A or over the patch 216B.

In the example illustrated in Figure 2A, the patch 202B is attached to the core substrate 204 via solder joints, including regular solder joints 210 and full IMC solder joints 206B and 206D. Similarly, the patch 202A is attached to the core substrate 204 via the regular solder joints 210 and the full IMC solder joints 206A and 206C. In one example, the patches are attached to the core substrate via a die attach process (e.g., thermocompression bonding (TCB) or other die attach method). The die attach process forms the solder joints from contacts and deposited solder paste. According to one example, when the patches 202A and 202B are attached to the core substrate 204, multiple re-flow steps are involved. Thus, the full IMC joints 206A-206D provide mechanical stability in disaggregated patch connection to prevent patch movement in downstream TCB processes.

Figure 2B illustrates another example in which full IMC joints can improve mechanical stability during assembly. In the example in Figure 2B, no-remelt solder paste is dispensed in substrate via openings to provide open cavity enforcement for bridge die interconnections. In the example illustrated in Figure 2B, a bridge die 228 is attached to the substrate 224 via a die attach process. Solder joints 226 and 220 are between the substrate 224 and the bridge die 228. A top die 230 can then be attached to the bridge die 228.

In the illustrated example, the full IMC solder joint 226 is formed in a via opening etched into the substrate 224. Thus, the substrate 224 includes a via opening 222 into which no-remelt solder paste is dispensed. Heat can then be applied to form the full IMC solder joint 226 from the no-remelt solder paste in the via opening 222. In another example, a conductive via can be formed (e.g., a copper via) and the no-remelt solder paste can be dispensed on the copper via and/or on the opposing pad, such as shown for the regular solder joint 220.

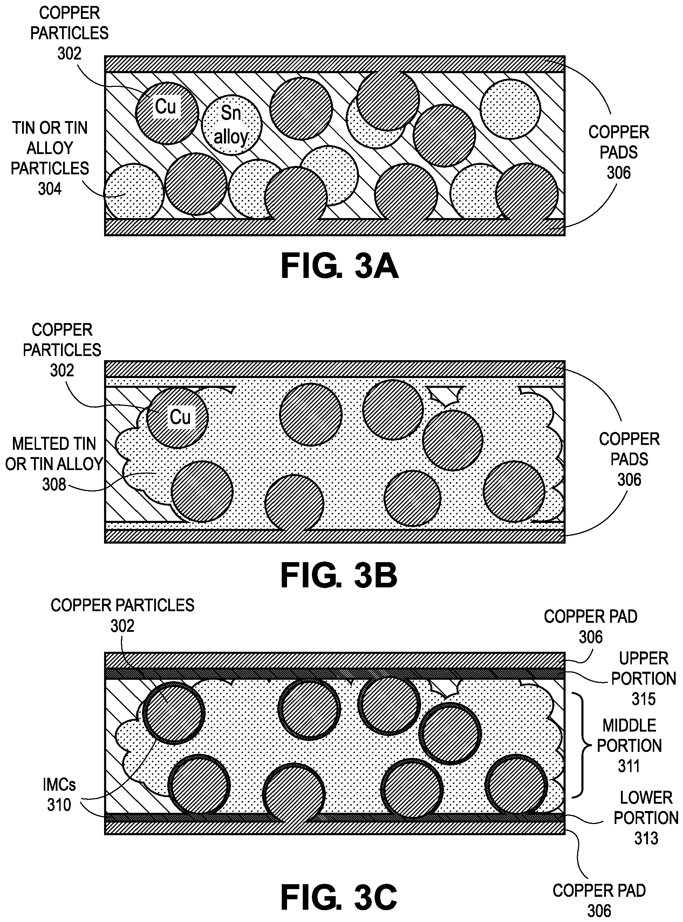

**Figures 3A-3C** illustrate full IMC joint formation with a solder paste. In one example, full IMC solder joints are formed with no-remelt solder paste. No-remelt solder paste is solder paste that, after passing through one reflow condition, does not melt again when undergoing subsequent reflow processes at typical reflow temperatures (e.g., up to 260-300 °C). Regular solder melts at typical reflow temperatures and becomes solid at room temperature. However, in contrast to no-remelt solder, regular solder melts again when heated to typical reflow temperatures again. For example, full IMC solder joints can be formed with transient liquid phase sintering (TLPS) paste. TLPS paste is a solder paste that can include copper (Cu) particles together with tin (Sn) or tin alloy particles (depending on the target reflow temperature) dispersed in a flux system. TLPS paste can be dispensed on copper pads using pin-dipping or other solder dispensing techniques. During reflow, the tin or tin alloy particles can melt and wet around the copper pads and copper particles in solder paste. Under heating, Sn and Cu will inter-diffuse to form Cu₃Sn intermetallic compounds (IMCs) inside solder paste and at the copper pads. Once the full IMC joints are formed, they can act as enforcement joints that do not melt again under regular reflow temperatures (e.g., <400 °C).

**Figure 3A** illustrates an example of solder paste dispensed between copper pads 306. The solder paste contains copper particles 302 and tin or tin alloy particles 304 throughout the solder paste between the copper pads 306. **Figure 3B** depicts how, under reflow temperature, the tin or tin alloy particles will melt (melted tin or tin alloy 308) and wet around the copper particles 302 and copper pads 306. **Figure 3C** illustrates an example of tin and copper particles inter-diffusing to form a full IMC joint. In the illustrated example, the full IMC joint includes both copper particles 302 and IMCs 310 throughout the solder joint, including throughout a middle portion 311 of the solder joint and in upper and lower portions 315 and 313 of the joint adjacent to the conductive contacts.

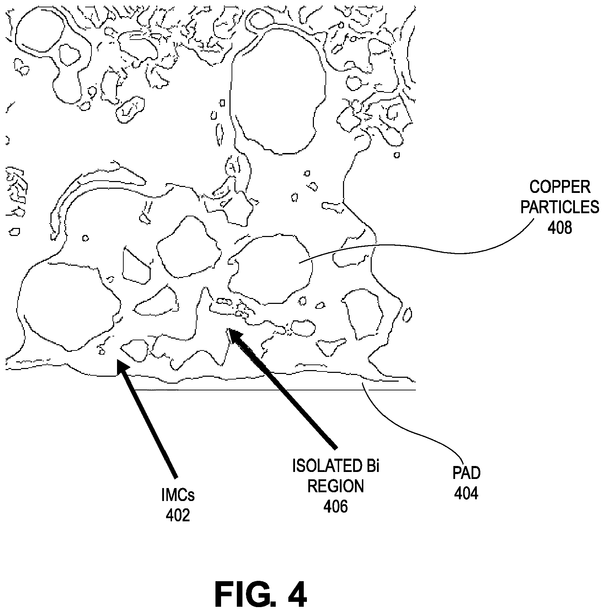

**Figure 4** illustrates a drawing of an example of IMCs post reflow. The example in Figure 4 depicts Sn/Bi alloy particles wetting around a copper pad 404 and copper particles 408 to form IMCs 402 and an isolated Bi region 406. In one example, the IMCs are formed throughout the joint through one or multiple stages of heating and cooling stages. For example, the Sn/Bi alloy particles melt at a relatively low remelt temperature (e.g., under 140 °C heating). The intermetallic compounds, such as Cu₃Sn, are then formed under heating. In one example, the Cu₆Sn5 is converted to Cu₃Sn IMCs under heating. After the IMCs are formed, subsequent heating at typical reflow temperatures may result in the bismuth region melting but does not cause the IMCs to melt.

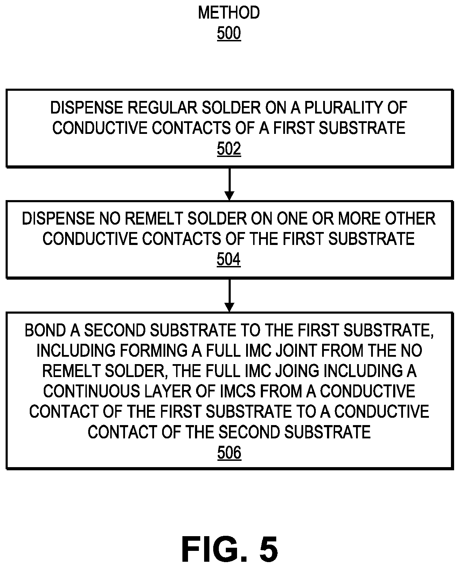

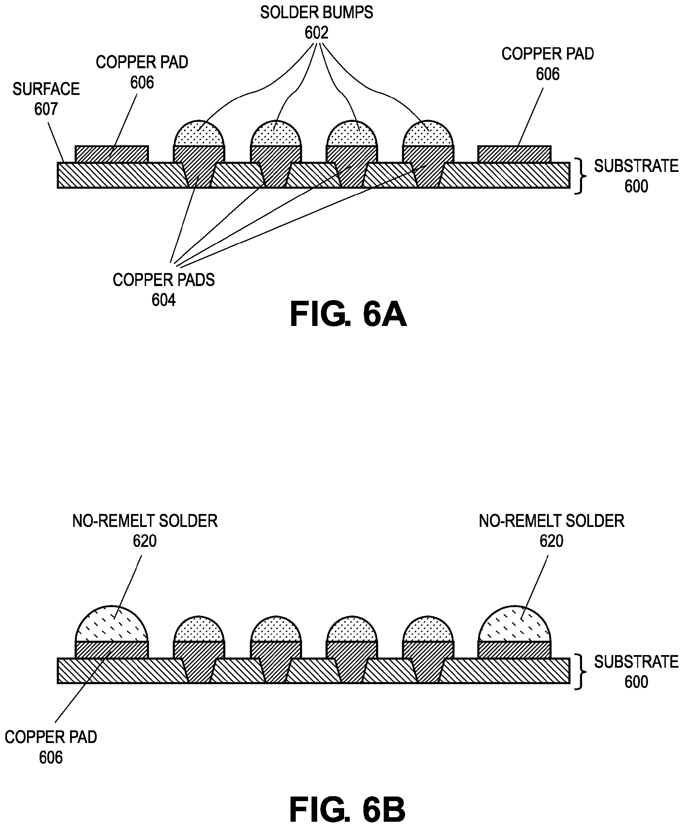

**Figure 5** is a flow diagram of an example of a process for the manufacture of a package with one or more full IMC joints. **Figures 6A-6D** illustrate cross-sectional views of various stages corresponding to the process of Figure 5, according to one example. Figures 6A-6D show an example of forming full IMC joints between dummy pads, however, the full IMC joints may also, or alternatively, be formed between pads for I/O or power delivery. In the example illustrated in Figures 6A-6D, the full IMC no-remelt solder joints are a supplementary enforcement to the regular solder connection and are formed together with regular solder joints.

Turning to Figure 5, in one example, the method 500 begins with dispensing regular solder on a plurality of conductive contacts of a first substrate, at block 502. For example, referring to Figure 6A, copper pads 604 and 606 were formed on a surface 607 of a substrate 600. In the example of Figure 6A, the copper pads 606 are dummy pads that are electrically isolated from conductive interconnects for I/O and power delivery in the first substrate. Regular solder bumps 602 are formed on the copper pads 604. Forming the regular solder bumps 602 may involve, for example, pin dipping or another technique for dispensing solder.

Referring again to Figure 5, no-remelt solder paste is dispensed on or more or other conductive contacts, at block 504. For example, referring to Figure 6B, no-remelt solder paste 620 is dispensed on the dummy copper pads 606. Dispensing the no-remelt solder paste may involve, for example, pin dipping or another technique for dispensing solder.

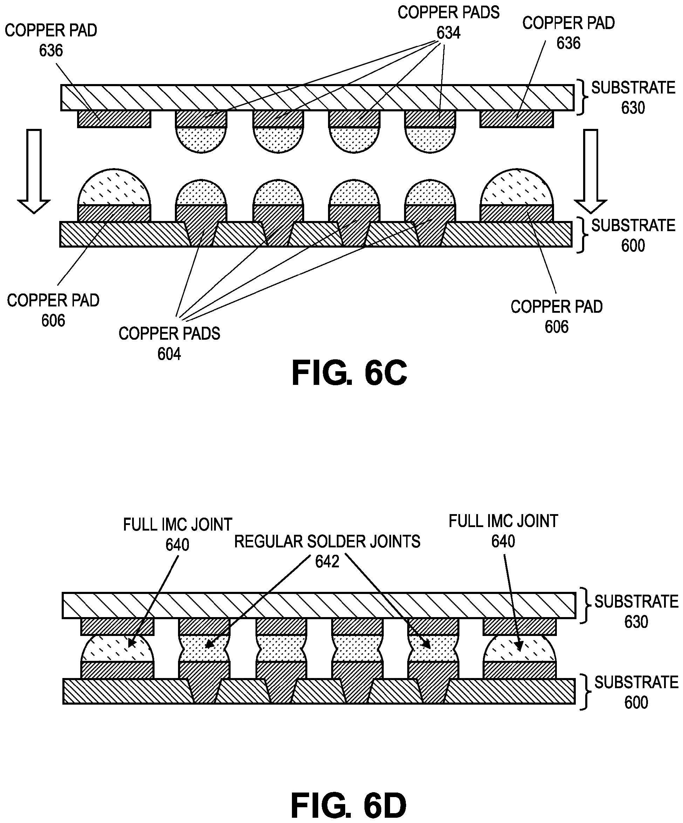

Referring again to Figure 5, after the regular and no-remelt solder paste is dispensed on the conductive contacts, a second substrate is bonded to the first substrate, at block 506. Bonding a second substrate to the first substrate may involve, for example, thermocompression bonding or other bonding technique. During thermocompression bonding, the second substrate is compressed on the first substrate. In one example, during the thermocompression bonding process, the regular solder bumps provide the bond head force as a reference to adjust die position. During the bonding process, the full IMC joints are formed from the no-remelt solder. Thus, in the same process, full IMC enforcement joints can be formed together with regular solder joints. Referring to Figure 6C, a second substrate 630 is bonded over the first substrate 600. The second substrate 630 includes a plurality of conductive contacts that correspond to the conductive contacts of the first substrate. For example, the second substate 630 includes dummy pads 636 that correspond to and are aligned with the dummy pads 606 of the first substrate 600. Similarly, the second substrate includes copper pads 634 that correspond to and are aligned with the copper pads 604 of the first substrate 600. Note that the example of Figure 6C depicts solder dispensed on the copper pads 634 of the second substrate 630, but not on the copper pads 636. In other examples, solder may also be dispensed on pads on one or both substrates. For example, solder may be dispensed on one or both of the copper pads 606 and 636, and one or both of the copper pads 604 and 634.

Figure 6D illustrates the regular and full IMC solder joints formed during the bonding process. In one example, the full IMC joints 640 and the regular solder joints 642 can be formed in the same step. As mentioned above, although some examples show the full IMC joints being formed between dummy pads, other examples may include full IMC joints being formed between active contacts in addition to, or alternatively to, the full IMC joints between dummy pads.

After the full IMC joints are formed at selected locations between the substrates, the full IMC enforcement joints will lock the die/substrate location in place. In the following downstream reflow steps, even though the regular solder joints may be softened, the substrates will not move due to the full IMC joints' integrity during the reflow processes.

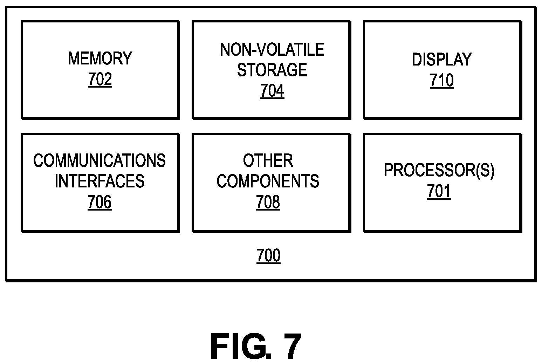

**Figure 7** provides an exemplary depiction of a computing system 700 (e.g., a smartphone, a tablet computer, a laptop computer, a desktop computer, a server computer, etc.). The system 700 may include one or more packages that include full IMC solder joints, as described herein.

As observed in Figure 7, the system 700 may include one or more processors or processing units 701. The processor(s) 701 may include one or more central processing units (CPUs), each of which may include, e.g., a plurality of general-purpose processing cores. The processor(s) 701 may also or alternatively include one or more graphics processing units (GPUs) or other processing units. The processor(s) 701 may include memory management logic (e.g., a memory controller) and I/O control logic.

The system 700 also includes memory 702 (e.g., system memory), non-volatile storage 704, communications interfaces 706, a display 710 (e.g., touchscreen, flat-panel), and other components 708. The other components may include, for example, a power supply (e.g., a battery or/or other power supply), sensors, power management logic, or other components. The communications interfaces 706 may include logic and/or features to support a communication interface. For these examples, communications interface 706 may include one or more communication interfaces that operate according to various communication protocols or standards to communicate over direct or network communication links or channels. Direct communications may occur via use of communication protocols or standards described in one or more industry standards (including progenies and variants) such as those associated with the PCIe specification. Network communications may occur via use of communication protocols or standards such those described in one or more Ethernet standards promulgated by IEEE. For example, one such Ethernet standard may include IEEE 802.3. Network communication may also occur according to one or more OpenFlow specifications such as the OpenFlow Switch Specification. Other examples of communications interfaces include, for example, a local wired point-to-point link (e.g., USB) interface, a wireless local area network (e.g., WiFi) interface, a wireless point-to-point link (e.g., Bluetooth) interface, a Global Positioning System interface, and/or other interfaces.

The computing system also includes non-volatile storage 704, which may be the mass storage component of the system. A non-volatile memory (NVM) device is a type of memory whose state is determinate even if power is interrupted to the device. In one embodiment, the NVM device may include block or byte-addressable, write-in-place memories. Examples may include, but are not limited to, single or multi-level Phase Change Memory (PCM) or phase change memory with a switch (PCMS), non-volatile types of memory that include chalcogenide phase change material (for example, chalcogenide glass), resistive memory including metal oxide base, oxygen vacancy base and Conductive Bridge Random Access Memory (CB-RAM), nanowire memory, ferroelectric random access memory (FeRAM, FRAM), magneto resistive random access memory (MRAM) that incorporates memristor technology, spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other types of block or byte-addressable, write-in-place memory. In one example, the non-volatile storage 704 may include mass storage that is composed of one or more SSDs (solid state drives), DIMMs (dual in line memory modules), or other module or drive.

Examples of assemblies, packages, systems, and methods of forming no-remelt solder enforcement joints follow.

Example 1: A microelectronic package including: a first substrate, a second substrate over the first substrate, and a plurality of solder joints between the first substrate and the second substrate, at least one of the plurality of solder joints including a continuous layer of intermetallic compounds (IMCs) from a conductive contact of the first substrate to a conductive contact of the second substrate.

Example 2: The microelectronic package of example 1, wherein: the solder joint including the continuous layer of IMCs includes copper particles throughout the solder joint, including throughout a middle portion of the solder joint between lower and upper portions adjacent to the conductive contacts of the first and second substrates.

Example 3: The microelectronic package of any of examples 1 or 2, wherein: the solder joint including the continuous layer of IMCs includes cured epoxy from a nO-remelt solder around the continuous layer of IMCs.

Example 4: The microelectronic package of any of examples 1-3, wherein: the solder joint has a melting point that is higher than other solder joints of the plurality of solder joints.

Example 5: The microelectronic package of any of examples 1-4, wherein: the solder joint is between dummy pads on the first and second substrates, wherein the dummy pads are electrically isolated from conductive interconnects for I/O and power delivery in the first and second substrates.

Example 6: The microelectronic package of any of examples 1-5, wherein: the solder joint includes an interconnect for power delivery between the first die and the second die.

Example 7: The microelectronic package of any of examples 1-6, wherein: the solder joint includes an input/output (I/O) interconnect between the first substrate and the second substrate.

Example 8: The microelectronic package of any of examples 1-7, wherein: the first substrate and the second substrate include one or more of: a substrate, a die, a bridge die, an interposer, a patch, a thin film, a motherboard, a redistribution layer (RDL), and an organic PCB.

Example 9: The microelectronic package of any of examples 1-8, wherein: the solder joint including the continuous layer of IMCs is located in a via in the first substrate.

Example 10: The microelectronic package of any of examples 1-9 wherein: the plurality of solder joints includes at least three solder joints each including a continuous layer of IMCs from a respective conductive contact of the first substrate to a respective conductive contact of the second substrate.

Example 11: The microelectronic package of any of examples 1-10, wherein: a number of the plurality of solder joints that include a continuous layer of IMCs from a respective conductive contact of the first substrate to a respective conductive contact of the second substrate is in a range of: one solder joint to 50% of the plurality of solder joints.

Example 12: A system including: a first substrate, a second substrate over the first substrate, the second substrate including an integrated circuit, and a plurality of solder joints between the first substrate and the second substrate, at least one of the plurality of solder joints including a continuous layer of intermetallic compounds (IMCs) from a conductive contact of the first substrate to a conductive contact of the second substrate.

Example 13: The system of example 12, further including one or more of: a processor, a memory die, a display, and a power source.

Example 14. The system of example 12 or 13, wherein any of the conductive contacts, solder joints, or substrates are in accordance with any of examples 1-13.

Example 15: A method including: dispensing solder on a plurality of conductive contacts of a first substrate, dispensing no-remelt solder on another conductive contact of the first substrate, and bonding a second substrate to the first substrate, including forming a solder joint from the no-remelt solder between the other conductive contact of the first substrate and a corresponding conductive contact of the second substrate, the solder joint including a continuous layer of intermetallic compounds (IMCs) from the other conductive contact of the first substrate to the conductive contact of the second substrate.

Example 16: The method of example 15, wherein: the no-remelt solder includes copper particles.

Example 17: The method of any of examples 15-16, wherein: the no-remelt solder includes an epoxy flux and has a higher melting point than the solder.

Example 18: The method of any of examples 15-17, wherein dispensing the no-remelt solder includes: dispensing the no-remelt solder on at least three conductive contacts of the first substrate,

Example 19: The method of any of examples 15-18, wherein dispensing the no-remelt solder includes: dispensing the no-remelt solder on one or more dummy pads on the first substrate, wherein the dummy pads are electrically isolated from conductive interconnects for I/O and power delivery in the first substrate.

Example 20: The method of any of examples 15-19, wherein dispensing the no-remelt solder includes: dispensing the no-remelt solder on one or more pads on the first substrate coupled with an interconnect for power delivery.

Example 21: The method of any of examples 15-20, wherein dispensing the no-remelt solder includes: dispensing the no-remelt solder on one or more pads on the first substrate coupled with an input/output (I/O) interconnect.

Example 22: The method of any of examples 15-21, wherein: the first substrate and the second substrate include one or more of: a substrate, a die, a bridge die, an interposer, a patch, a thin film, a motherboard, and an organic PCB.

Example 23: The method of any of examples 15-22, wherein dispensing the no-remelt solder includes: dispensing the no-remelt solder into a via in the first substrate.

Example 24: The method of any of examples 15-23, wherein dispensing the no-remelt solder includes: dispensing the no-remelt solder on a number of conductive contacts of the first substrate in a range of: one conductive contact to 50% of the conductive contacts of the first substrate.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

The hardware design embodiments discussed above may be embodied within a semiconductor chip and/or as a description of a circuit design for eventual targeting toward a semiconductor manufacturing process. In the case of the later, such circuit descriptions may take of the form of a (e.g., VHDL or Verilog) register transfer level (RTL) circuit description, a gate level circuit description, a transistor level circuit description or mask description or various combinations thereof. Circuit descriptions are typically embodied on a computer readable storage medium (such as a CD-ROM or other type of storage technology).

Note that terms such as "upper," "lower," "over," "under," and other terms describing the position of various elements with respect to one another are used as examples and are not intended as limiting. For example, a substrate that is described as over another substrate could also be described as being under the substrate when viewed from a different perspective.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A microelectronic package comprising:
a first substrate;
a second substrate over the first substrate; and
a plurality of solder joints between the first substrate and the second substrate, at least one of the plurality of solder joints including a continuous layer of intermetallic compounds (IMCs) from a conductive contact of the first substrate to a conductive contact of the second substrate.

2. The microelectronic package of claim 1, wherein:
the solder joint including the continuous layer of IMCs includes copper particles throughout the solder joint, including throughout a middle portion of the solder joint between lower and upper portions adjacent to the conductive contacts of the first and second substrates.

3. The microelectronic package of one of the previous claims, wherein:
the solder joint including the continuous layer of IMCs includes cured epoxy from a no-remelt solder around the continuous layer of IMCs.

4. The microelectronic package of one of the previous claims, wherein:
the solder joint has a melting point that is higher than other solder joints of the plurality of solder joints.

5. The microelectronic package of one of the previous claims, wherein:
the solder joint is between dummy pads on the first and second substrates, wherein the dummy pads are electrically isolated from conductive interconnects for I/O and power delivery in the first and second substrates.

6. The microelectronic package of one of the previous claims, wherein:
the solder joint includes an interconnect for power delivery between the first substrate and the second substrate.

7. The microelectronic package of one of the previous claims, wherein:
the solder joint includes an input/output (I/O) interconnect between the first substrate and the second substrate.

8. The microelectronic package of one of the previous claims, wherein:
the first substrate and the second substrate include one or more of: a substrate, a die, a bridge die, an interposer, a patch, a thin film, a motherboard, a redistribution layer (RDL), and an organic PCB.

9. The microelectronic package of one of the previous claims, wherein:
the solder joint including the continuous layer of IMCs is located in a via in the first substrate.

10. The microelectronic package of one of the previous claims, wherein:
the plurality of solder joints includes at least three solder joints each including a continuous layer of IMCs from a respective conductive contact of the first substrate to a respective conductive contact of the second substrate.

11. The microelectronic package of one of the previous claims, wherein:
a number of the plurality of solder joints that include a continuous layer of IMCs from a respective conductive contact of the first substrate to a respective conductive contact of the second substrate is in a range of: one solder joint to 50% of the plurality of solder joints.

12. A method comprising:
dispensing solder on a plurality of conductive contacts of a first substrate;
dispensing no-remelt solder on another conductive contact of the first substrate; and
bonding a second substrate to the first substrate, including forming a solder joint from the no-remelt solder between the other conductive contact of the first substrate and a corresponding conductive contact of the second substrate, the solder joint including a continuous layer of intermetallic compounds (IMCs) from the other conductive contact of the first substrate to the conductive contact of the second substrate.

13. The method of claim 12, wherein:
the no-remelt solder includes copper particles.

14. The method of claim 12 or 13, wherein:
the no-remelt solder includes an epoxy flux and has a higher melting point than the solder.

15. The method of claim 12, 13 or 14, wherein dispensing the no-remelt solder comprises: dispensing the no-remelt solder on at least three conductive contacts of the first substrate.
